# EUROPEAN PATENT APPLICATION

(11) **EP 2 559 930 A1**
(43) Date of publication of application: **20.02.2013**
(21) Application number: 11187975.5
(22) Date of filing: 04.11.2011
(51) Int. Cl.: F21K 99/00, H05K 1/02, F21Y 101/02, F21Y 111/00

(54) **Three-dimensional tensile and helical circuit board for light-emitting diode lamp and manufacturing method thereof**

(30) Priority: 16.08.2011 CN 201110233565
(71) Applicant: Wu, Guang-Yi, Shengzhou City, Zhejiang (CN); Xiang, Shao-Ai, Shengzhou City, Zhejiang (CN)
(72) Inventor: Wu, Guang-Yi, Shengzhou City, Zhejiang (CN); Xiang, Shao-Ai, Shengzhou City, Zhejiang (CN)
(74) Representative: Chaillot, Geneviève

(57) **Abstract**

The invention discloses a method for manufacturing a three-dimensional tensile and helical circuit board (1) for a LED lamp comprises the steps of: forming a helical continuous carved wire slot on a circuit board; providing patch light-emitting diode tubes (4) to be welded in between the helical continuous carved wire slot; and directly tensioning a center of the circuit board and lifting the tensioned circuit board along the helical continuous carved wire slot to form as the three-dimensional tensile and helical circuit board (1). The invention enable the light to be uniformly projected on a lamp shade from the LED patches, realizing the LED lamp with a long life span, low manufacturing cost and excellent reliability.

## Description

### BACKGROUND OF THE INVENTION

### Field of the Invention

The invention relates to a three-dimensional tensile and helical circuit board for a light-emitting diode lamp and a manufacturing method thereof.

### Description of the Related Art

Conventional light-emitting diode (LED) lamps are usually applied with planar circuit boards which are inserted with lamp bulbs or installed with LED patches thereon. To obtain the lamp bulbs with uniform illumination, the lamp bulbs arranged in a pyramid-like inserting configuration are applied. However, because the LED patches only suitable for being planarly installed, the light cannot be uniformly projected on a lamp shade from the LED patches.

### BRIEF SUMMARY OF THE INVENTION

The topic of the invention is to solve this difficult issue, enabling the light to be uniformly projected on the lamp shade from the LED patches. The purpose of the invention is to provide a three-dimensional tensile and helical circuit board for a light-emitting diode lamp and a manufacturing method thereof, enabling the light to be uniformly projected from the LED patches. Thus, the LED lamp with a long life span, low manufacturing cost and excellent reliability can be realized.

To achieve the purposes above, the invention is adopted with the technology projects as follows. The invention is to provide a three-dimensional tensile and helical circuit board for a light-emitting diode lamp. A three-dimensional helical circuit board after being tensioned comprises a chassis and a patch-mounting portion integrally formed with the chassis, and patch light-emitting diode tubes are installed on the patch-mounting portion.

The printed circuit board may be selected of one of an epoxy circuit board or aluminum-base circuit board.

The engaging elements may be installed on the patch-mounting portion, and a supporting post may be installed between the engaging elements.

A method for manufacturing a three-dimensional tensile and helical circuit board for a LED lamp comprises the steps of: forming a helical continuous carved wire slot on a circuit board; providing patch light-emitting diode tubes 4 to be welded in between the helical continuous carved wire slot; and directly tensioning a center of the circuit board and lifting the tensioned circuit board along the helical continuous carved wire slot to form as the three-dimensional tensile and helical circuit board.

The effect of the invention is that the light can be uniformly projected on a lamp shade from the LED patches, realizing the LED lamp with a long life span, low manufacturing cost and excellent reliability.

A detailed description is given in the following embodiments with reference to the accompanying drawings.

### BRIEF DESCRIPTION OF THE DRAWINGS

The invention can be more fully understood by reading the subsequent detailed description and examples with references made to the accompanying drawings, wherein:

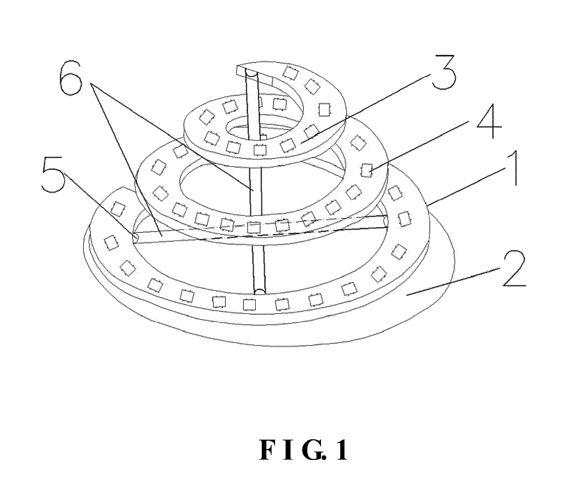

Fig. 1 is a schematic view of the structure of the invention.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

Referring to Fig. 1, a three-dimensional tensile and helical circuit board disposed on a light-emitting diode (LED) lamp of an embodiment comprises a step of directly tensioning a center of a planar printed circuit board (PCB) and lifting the tensioned PCB to form a three-dimensional tensile and helical PCB 1. The PCB 1 comprises a chassis 2 and a patch-mounting portion 3 integrally formed with the chassis 2, capable of being selected of one of an epoxy circuit board or aluminum-base circuit board. Patch light-emitting diode tubes 4 are installed on the patch-mounting portion 3, and the chassis2 is fixedly engaged to an inner wall of a lamp housing. To secure the main body of the PCB 1, engaging elements 5 are installed on the patch-mounting portion 3, and a supporting post 6 is installed between the engaging elements 5. A method for manufacturing the three-dimensional tensile and helical circuit board disposed on the LED lamp comprises the steps of: forming a helical continuous carved wire slot on a circuit board; providing patch light-emitting diode tubes 4 to be welded in between the helical continuous carved wire slot; and directly tensioning a center of the circuit board and lifting the tensioned circuit board along the helical continuous carved wire slot to form as the three-dimensional tensile and helical circuit board. The invention enables the light to be uniformly projected on a lamp shade from the LED patches, realizing the LED lamp with a long life span, low manufacturing cost and excellent reliability.

## Claims

1. A three-dimensional tensile and helical circuit board for a light-emitting diode lamp, **characterized in that** a three-dimensional helical circuit board (1) after being tensioned comprises a chassis (2) and a patch-mounting portion (3) integrally formed with the chassis (2), and patch light-emitting diode tubes (4) are installed on the patch-mounting portion (3).

2. The three-dimensional tensile and helical circuit board for the light-emitting diode lamp as claimed in claim 1, **characterized in that** the printed circuit board (1) is selected of one of an epoxy circuit board or aluminum-base circuit board.

3. The three-dimensional tensile and helical circuit board for the light-emitting diode lamp as claimed in claim 1, **characterized in that** engaging elements are installed on the patch-mounting portion (3), and a supporting post (6) is installed between the engaging elements (5).

4. A method for manufacturing a three-dimensional tensile and helical circuit board for a light-emitting diode lamp as claimed in claim 1, **characterized in that** the method comprises the steps of:
forming a helical continuous carved wire slot on a circuit board;
providing patch light-emitting diode tubes to be welded in between the helical continuous carved wire slot; and
directly tensioning a center of the circuit board and lifting the tensioned circuit board along the helical continuous carved wire slot to form as the three-dimensional tensile and helical circuit board.
